# EUROPEAN PATENT SPECIFICATION

(11) **EP 0 901 746 B1**
(45) Date of publication and mention of the grant of the patent: **18.08.2004**
(21) Application number: 97916879.6
(22) Date of filing: 20.03.1997
(51) Int. Cl.: H05K 7/20, H01L 35/32, H01L 35/34

(54) **THERMOELECTRIC MODULE WITH GAPLESS EGGCRATE**
THERMOELEKTRISCHES MODUL MIT EINEM LÜCKENLOSEN EIERSCHACHTEL
MODULE THERMOELECTRIQUE COMPORTANT UN CASIER ALVEOLE SANS INTERSTICES

(30) Priority: 20.05.1996 US 650299
(43) Date of publication of application: 17.03.1999
(73) Proprietor: HI-Z Technology, Inc., San Diego, CA 92126-4202 (US); Leavitt, Frederick A., San Diego, CA 92129 (US); Bass, John C., La Jolla, CA 92037-6933 (US); Elsner, Norbert, La Jolla, CA 92037 (US)
(72) Inventor: LEAVITT, Frederick, A., San Diego, CA 92129 (US); BASS, John, C., La Jolla, CA 92037-6933 (US); ELSNER, Norbert, La Jolla, CA 92037 (US)
(74) Representative: Howden, Christopher Andrew
(86) International application number: PCT/US1997/004514
(87) International publication number: WO 1997/044993

(56) References cited:
- GB-A- 912 001
- GB-A- 1 264 550
- US-A- 3 830 664
- US-A- 4 497 973
- US-A- 4 611 089
- US-A- 4 734 139
- US-A- 4 859 250
- US-A- 5 064 476
- US-A- 5 367 890
- US-A- 5 436 467
- US-A- 5 448 109
- US-A- 5 625 245

## Description

The present invention relates to thermoelectric devices and in particular to modular thermoelectric devices.

### BACKGROUND OF THE INVENTION

Thermoelectric devices are well known. These devices utilize physics principals known as the Seebeck effect discovered in 1821 and the Peltier effect discovered in 1834. The Seebeck principle tells us that if two wires of different materials (such as copper and iron) are joined at their ends, forming two junctions, and one junction is held at a higher temperature than the other junction, a voltage difference will arise between the two junctions. The Peltier effect describes an inverse effect. If current is sent through a circuit made of dissimilar materials, heat will be absorbed at one junction and given up or evolved at the other junction.

Most thermoelectric devices currently in use today to generate electricity or for cooling utilize semiconductor materials (such as bismuth telluride) which are good conductors of electricity but poor conductors of heat. These semiconductors are typically heavily doped to create an excess of electrons (n-type) or a deficiency of electrons (p-type). An n-type semiconductor will develop a negative charge on the cold side and a p-type semiconductor will develop a positive charge on the cold side.

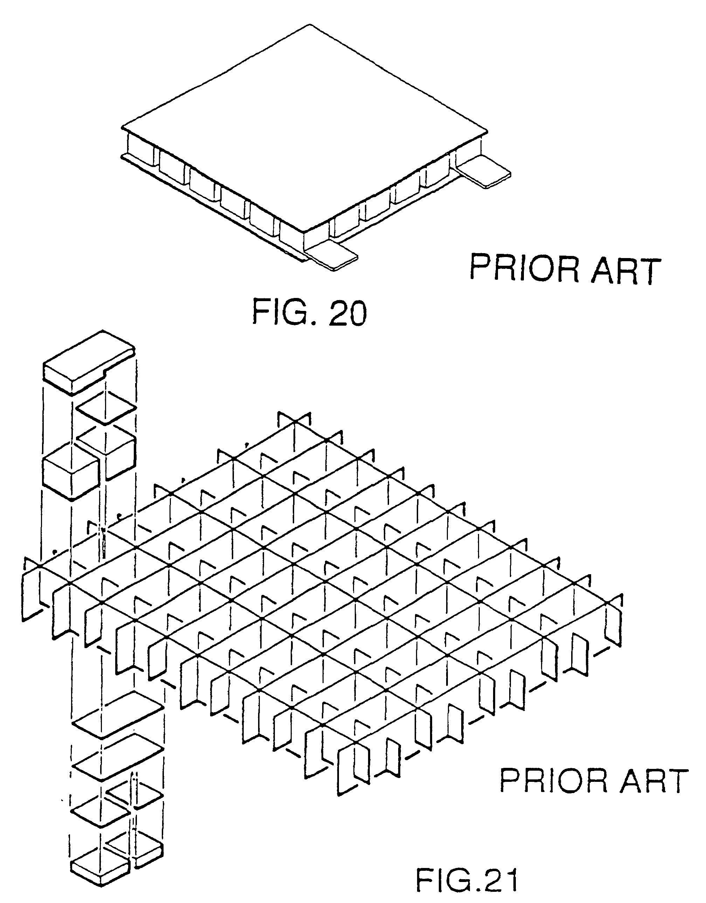

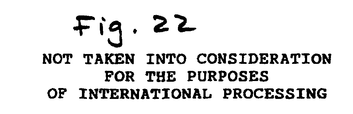

Since each element of a semiconductor thermoelectric device will produce only a few millivolts it is generally useful to arrange the elements in series so as to produce higher voltages for the generation of electricity or to permit use of higher voltages for cooling. Several techniques have been developed for arranging the semiconductor elements in series in thermoelectric devices. One such prior art method is shown in FIG. 20. In this device p and n type semiconductors are arranged in a checkerboard pattern and electrical jumpers are soldered, each to two different semiconductors, at the cold side and at the hot side so as to place all of the semiconductor elements in series with each other. This method is a low cost method and well established but has some limitations. Above 100 C the solders will defuse into the thermoelectric elements destroying them. In a high humidity atmosphere moisture may condense in the spaces between the elements and thermally short the module. The structure is not mechanically strong and easily fractures.

Another currently used method is the so-called eggcrate design shown in FIG. 21. Here an "eggcrate" made of insulator material separates the thermoelectric elements and permits electrical jumpers to be pressed against the elements to provide a good electrical connection without solder. It is also known to spray a conductor material on each side of these eggcrates to provide electrical connections. In prior art designs, the eggcrates are fabricated from individual strips which have been cut to shape having a series of slots using a precision laser cutter. The strips are then assembled into an eggcrate by interlocking the laser machined slots. All of the elements can be connected in series by proper construction of the eggcrate. Obviously it is possible in both devices to arrange for any desired number of elements to be in series. Thus, several elements in series may form a series set and this set could be arranged in parallel with other similar sets. The major disadvantage of prior art eggcrates is illustrated in FIG. 21. As is apparent in FIG. 21, gaps at junctions formed by the intersecting strips can permit electrical shorts between adjacent cells to occur, especially if electrical jumpers are applied using techniques such as metal spraying. Such shorts obviously could substantially degrade performance, reducing the power output of the module.

GB-A-912,001 describes a method of producing a thermoelectric assembly comprising the steps of forming a egg-crate shaped structure with thermoelectric elements disposed in open-ended compartments thereof; applying and joining conductive means to plates in predetermined arrays; sandwiching said egg-crate shaped structure between said plates and joining said conductive means to the end faces of said elements.

Also, prior art eggcrate modules are expensive due primarily to the fact that labour costs to assemble the eggcrates and to install the elements in the crates is expensive. What is needed is a gapless, lower cost thermoelectric eggcrate module.

### SUMMARY OF THE INVENTION

The present invention provides a method of fabricating a thermoelectric module. The thermoelectric module contains thermoelectric elements installed in an gapless eggcrate. An eggcrate having walls without gaps is formed using a technique such as injection molding. This gapless eggcrate provides insulated spaces for a large number of p-type and n-type thermoelectric elements. The absence of gaps in the walls of the spaces virtually eliminates the possibility of interwall shorts between the elements even when electrical connections are made by metal spray techniques. Fabrication of the gapless eggcrate can be automated using several available techniques such as molding and casting to greatly reduce the labor cost of fabricating thermoelectric eggcrates as compared to prior art techniques of fabricating eggcrates. Thermoelectric elements, both p-type and n-type, are fabricated and are inserted into the insulated spaces in the gapless eggcrate in a predetermined manner to provide the desired thermoelectric effects for a predetermined type of application. Electrical connections are established on both the hot and cold sides of the module to connect the thermoelectric elements in series or parallel as desired. Normally, most or all of the elements will be connected in series.

In a preferred embodiment of the present invention the gapless eggcrate is formed from a high temperature plastic. In this embodiment p-type thermoelectric material is extruded and then sliced and diced to form p-type thermoelectric elements, and n-type thermoelectric material is extruded and sliced and diced to form n-type thermoelectric elements. The n and p-type elements can also be sliced and diced from cast material or hot pressed material. The thermoelectric elements are loaded in the eggcrate in an arrangement to put them all in series when a metal spray is applied to the hot and cold sides. Two electrical leads are applied and electrical connections on both the hot and cold sides are provided using a metal thermal spray technique. A thin layer of molybdenum is sprayed on one of the surfaces and then a coating of aluminum is sprayed over the molybdenum. These steps are repeated for the other side. Then the surfaces are ground down to expose the insulating eggcrate walls except where connections between the elements are desired. In this preferred embodiment a seal is then applied over both the hot and cold surfaces. The seal preferably is comprised of a very thin electrically insulating layer such as Dupont Kapton film and over this electrically insulating layer a layer of aluminum is provided.

In a preferred embodiment of the present invention, eight of the modules are arranged to create an electric generator capable of producing about 62 watts of electrical power at 12 volts from hot and cold fluids at a temperature difference of about 300 degrees Fahrenheit. The thermoelectric modules are held in close contact with a hot side heat source and a cold side heat sink with a spring force provided by Belville springs.

### BRIEF DESCRIPTION OF THE DRAWINGS

FIGS. 1 A and B are two views of an eggcrate according to the present invention.
FIGS. 2 through 9 and 11 are section views of the above eggcrate.
FIG. 10 show an end view.
FIGS. 12 and 14 show a preferred element arrangement.
FIG. 13 shows an enlarged view of a portion of a cross section of a module showing parts of the eggcrate the elements and metal coatings.
FIGS. 15 A and B and 16 A and B show a mold for making the eggcrate.
FIG. 17 shows our injection molding process.
FIG. 18 shows the mold fitted together.
FIG. 19 shows our metallizing process.
FIG. 20 shows a prior art thermoelectric device.
FIG. 21 shows details of a prior art eggcrate device.
FIG. 23 is a section view of the thermoelectric generator shown in FIG. 24.
FIG. 24 is an outline drawing of a preferred embodiment thermoelectric generator.
FIG. 25 shows where the thermoelectric generator fits in a well head dehydration plant.
FIG. 26 shows curves of power output as a function of glycol flow rate for several hot glycol temperatures.
FIG. 27 shows the thermoelectric module covered by seals comprising insulating and conductive layers.

### DETAILED DESCRIPTION OF PREFERRED EMBODIMENTS

A preferred embodiment of the present invention can be fabricated as set forth below:

### FABRICATING THE EGGCRATE

### Injection Molded Eggcrate

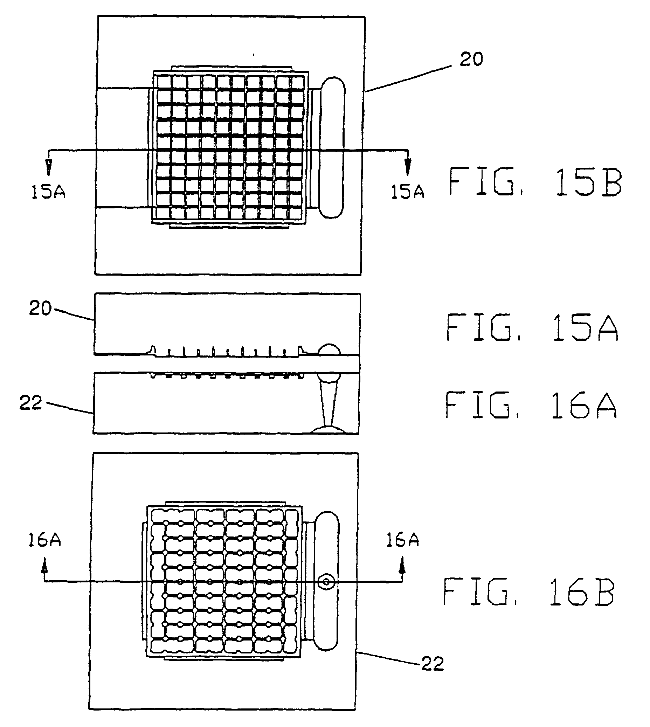

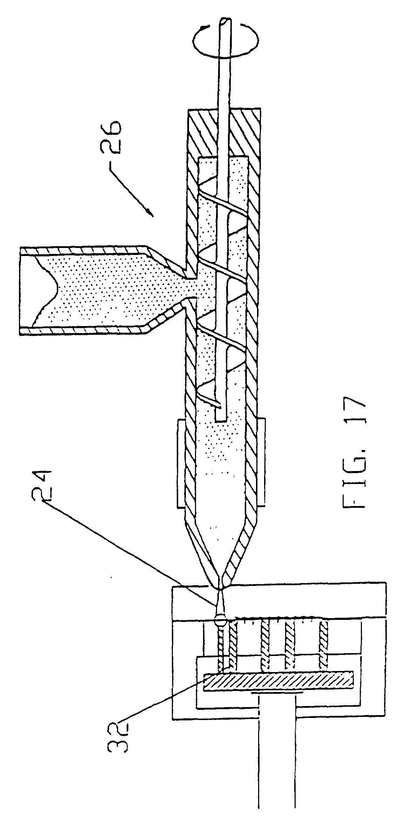

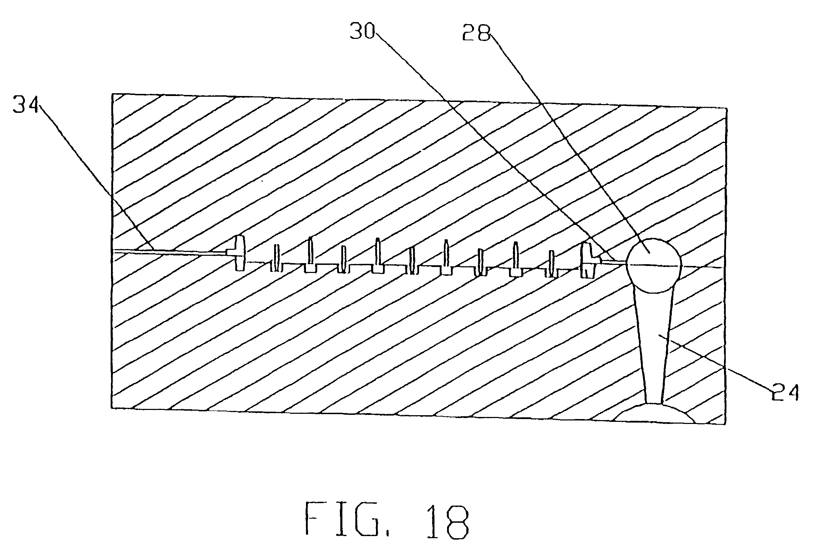

The eggcrate for this preferred embodiment is injection molded using the mold pattern shown in FIGS. 15 A and B and 16 A and B. FIGS. 15 A and B show the bottom 20 of the mold pattern and FIGS 16 A and B show the top 22 of the pattern. The top and bottom are shown in their molding position in FIG. 18. A high temperature thermo plastic, such as the liquid crystal polymer resin, Dupont Zenite, is injected through sprue 24 using well known plastic molding techniques in an injection molding machine 26 such as the one depicted in FIG. 17. With the Dupont Zenite plastic the dryer is maintained at 275 F and the barrel temperatures range from 625 F at the rear to 640 F near the nozzle. Both the bottom mold and the top mold are maintained at a temperature of about 200 F. Zenite melts at about 550 °F. In the usual manner the fluid plastic passes through sprue 24, runner 28, and gate 30 into the mold cavity. The vent is shown at 34 in FIG. 18. The finished part is ejected by injection pins 32 as shown in FIG. 17. Initial production runs made by applicants supplier have produced excellent eggcrates at a rate of about 50 eggcrates per hour. This rate can easily be increased to 200 eggcrates per hour for one worker and ultimately the process can be completely automated. This compares to a one worker production rate of about 3 eggcrates per hour with the prior art method of assembling thermoelectric module eggcrates from appropriately slotted layers of insulating materials.

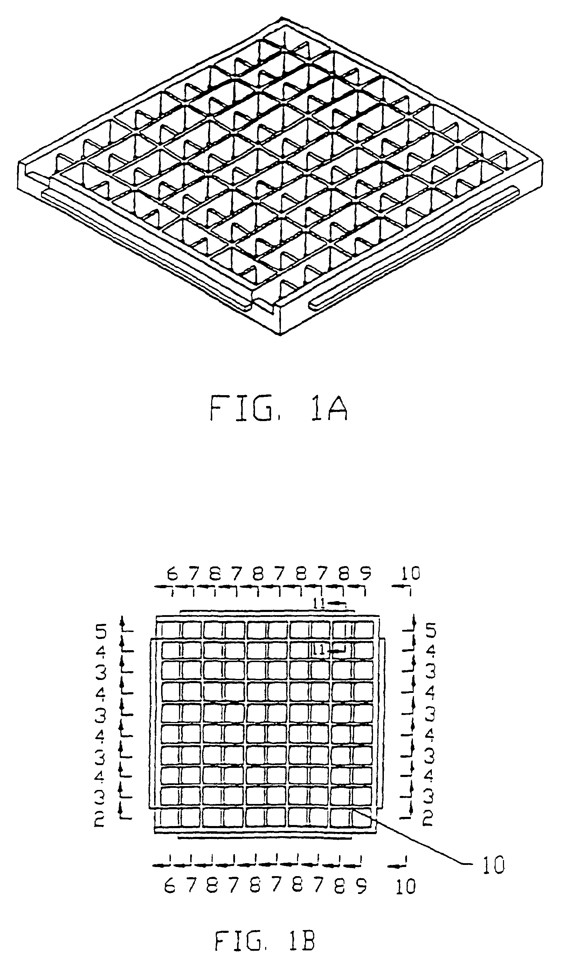

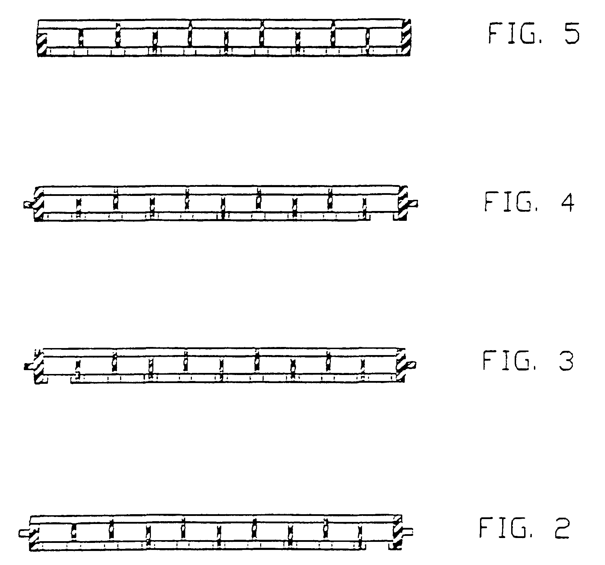

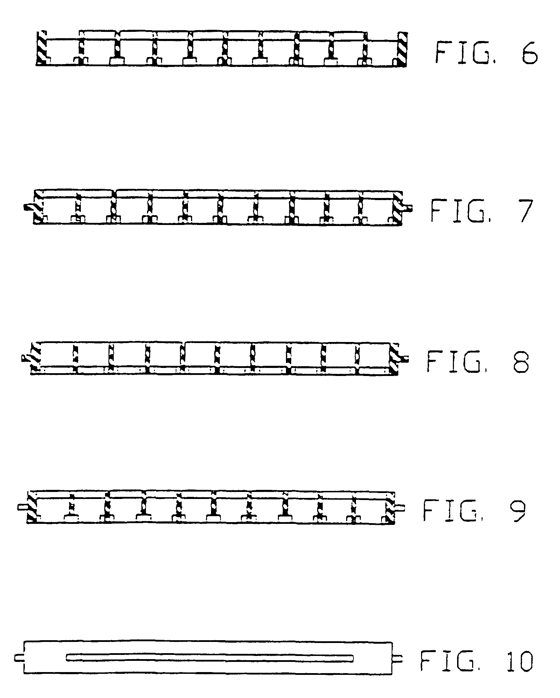

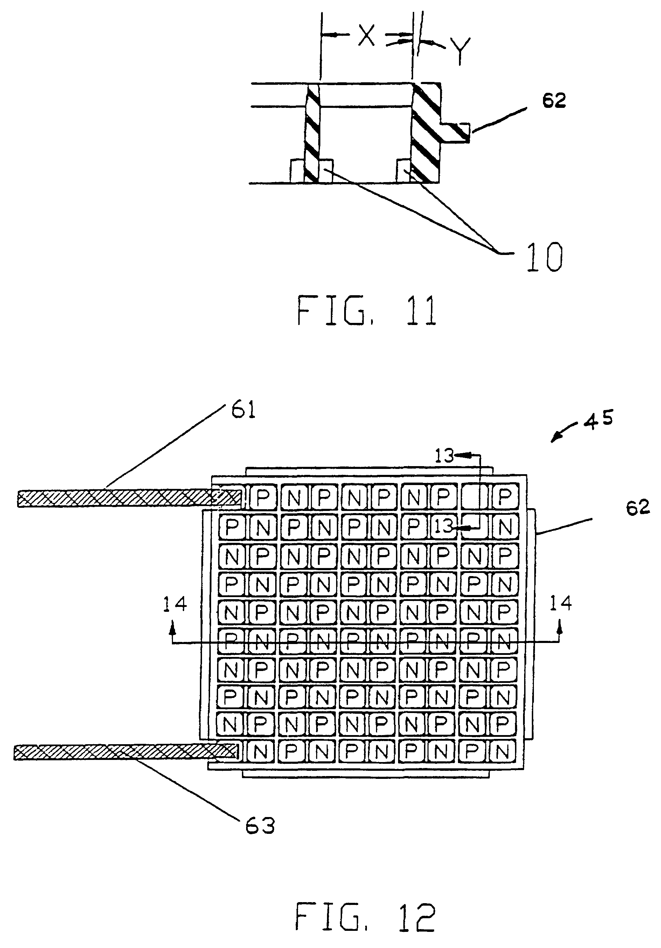

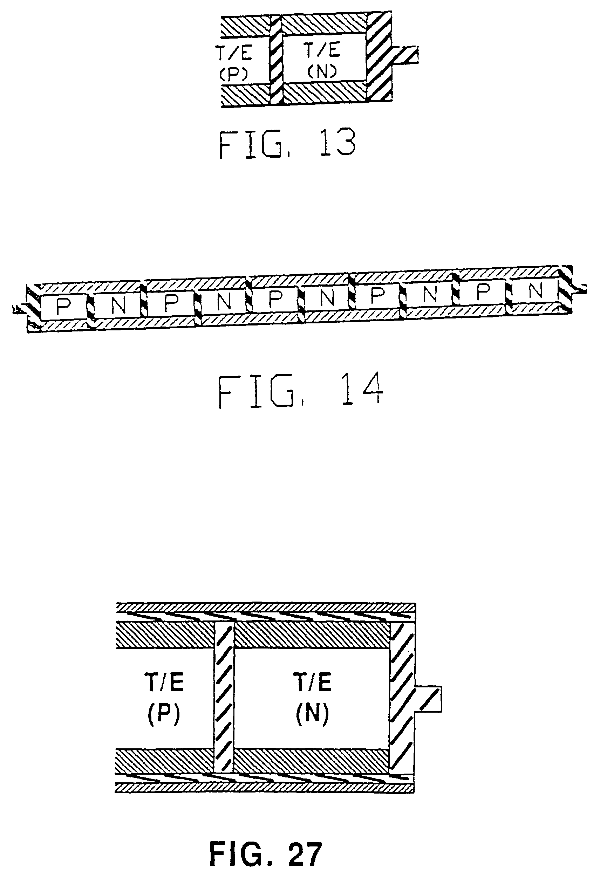

The completed injection molded eggcrate is shown in FIG. 1 A. This embodiment contains boxes (spaces) for 100 thermoelectric elements. In a preferred embodiment two of the corner spaces are eliminated to make a stronger base for electrical leads. The dimension of the elements are 5.1 mm X 5.1 mm X 3.0 mm. The dimension of the spaces at the bottom of the eggcrate are 5.1 mm X 5.1 mm. A top view of the eggcrate is shown in FIG.1. FIGS 2 through 9 show various section through the eggcrate. FIG. 10 is a side view and FIG. 11 is a sectional view which shows an expanded view of one of the boxes created by the eggcrate. Note that the upper part of the walls of the box is tapered 5 degrees as shown at Y in FIG. 11. In this embodiment the straight part of the walls of the box forms a 0.2 inch square as shown at X in FIG. 11. This dimension is held to a tolerance of plus 0.001 inch to provide a tight fit for thermoelectric elements which are 0.200 inch square with a tolerance of minus 0.001. Note that a support ridge 62 as shown in FIGS. 11 and 12 is provided around the boundary of the eggcrate at the midplane between the two surface planes of the eggcrate. This support ridge provides extra strength for the eggcrate and is utilized during subsequent stages of module fabrication and can be useful in mounting the completed module for use.

FIG. 12 shows a top view of the eggcrate with the locations indicated for the P and N elements. The elements are placed in these locations with the installer assuring that each element rest firmly against stops 10 as shown in FIGS. 1 and 11. Conductor material is then sprayed on the top and bottom of the eggcrate and then the tops and bottoms are ground down until the tops of all insulator surfaces are cleared of conductor material. A preferred procedure for loading the eggcrate is discussed in detail below. FIGS 13 and 14 show examples of sections of the finished product at location 13-13 and 14-14 as shown in FIG. 12. Note in FIG. 14 how the effect is to connect all the thermoelectric elements in series electrically. In this particular section the hot surface is on the top and the electron flow is from left to right.

### INSTALLATION OF THERMOELECTRIC ELEMENTS

### Thermoelectric Elements

Thermoelectric elements with dimensions of 5.1 mm X 5.1 mm X 3.0 mm are prepared using any of several well known techniques such as those described in Thermoelectric Materials edited by Sittig, published in 1970 by Noyes Data Corporation, Park Ridge, New Jersey. Preferred materials are Lead Telluride for high temperature applications and Bismuth Telluride for low temperature applications. These elements may also be purchased commercially from suppliers such as Melcor Corporation with offices in Trenton, New Jersey. One half of the elements should be "n" elements and one half "p" elements.

### Loading the Eggcrates

Position "p" elements in the appropriate boxes of the egg create as shown in FIG. 12. Ensure that the element is snug against the stop. Position "n" elements in the appropriate boxes of the egg crate as shown in FIG. 12. Ensure that each element is snug against the stop. Insert a 2 inch long 1/8 inch wide copper mesh wire lead at positions 61 and 63 as shown in FIG. 12. Alternatively, the corner positions where the leads are attached could be modified so that instead of a space at these two positions, the space is solid eggcrate material, and is molded with these two positions filled with solid plastic. Thus, no corner element is present in the position where the copper lead connection is made. So in this embodiment the P position where lead 61 attaches is solid plastic (about 0.5 cubic centimeter) and the N position where lead 63 attaches is solid plastic (about 0.5 cubic centimeter). This improves the ability to automate the welding of the copper lead to the eggcrate. On the hot side of the module this plastic extends to the full height of the egg crate walls but on the cold side the plastic only extends to the same height as the adjacent element. The copper lead (item 61 & 63 of Fig 12) is positioned over the plastic where the element would normally have been placed and using a parallel gap spot welder the copper lead is heated to the point where the plastic begins to soften and the lead is pressed into the softened plastic. Having the solid plastic corner to bond the copper lead to is an important advantage since it prevents the comer element from heating excessively and melting the "stops" (item 10 of FIG. 1 and FIG. 11). When the stops melt, the compressive force from the parallel gap welder can move the corner element out of position thereby compromising the module integrity. Since the difficult weld made to the corner elements required tight specifications the process would be difficult to automate. Welding the leads into plastic is simple and tolerant of varying welding parameters. Other problems that are eliminated are cracked corner legs and weak welds caused by the difficulty of welding copper leads to corner elements.

### PROVIDING ELECTRICAL CONNECTIONS FOR THERMOELECTRIC ELEMENTS

### Metallizing the Hot and Cold Surfaces

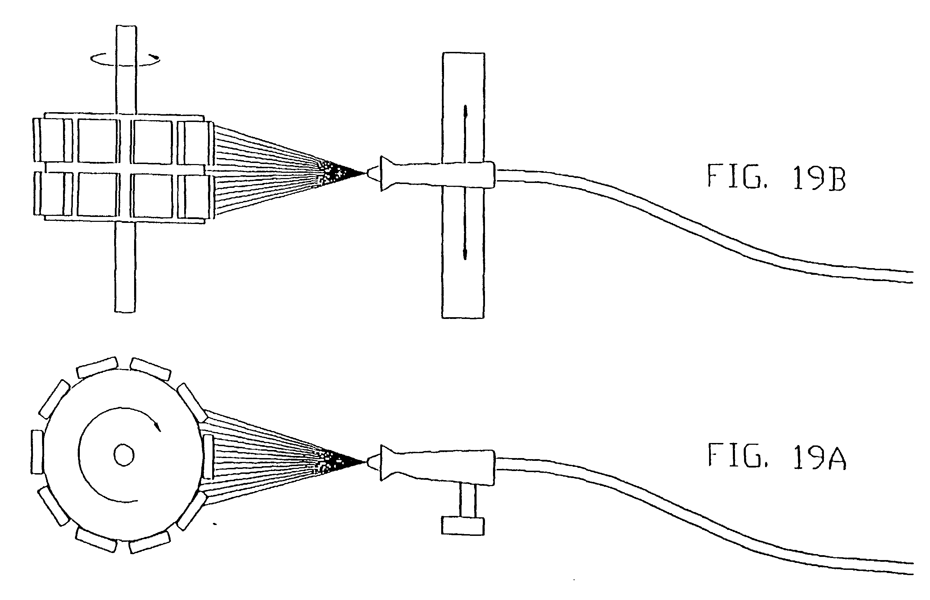

Using spring loaded clamps, we clamp a number of modules to a rotatable mandrel. In FIGS. 19 A and B we show 20 modules clamped to such a mandrel. We then grit blast the module/element surface with 180-240 grit Al₂O₃ to a uniform matte finish with the mandrel rotating at 55 rpm. Then we use compressed air to blow the module/element surface clean. Next we apply a metal thermal spray coating to the exposed surface using a thermal spray coating system as shown in FIGS. 19 A and B. These spray techniques are well known. Further specific details are provided in Metals Handbook, Ninth Edition, published by the American Society for Metals. A variety of metals can be used to coat the surface. Our preferred coating is a two-layer coating comprising a first 0.006 inch thick coating of molybdenum and a second 0.06 inch thick coating of aluminum. The molybdenum is deposited so the surface is coated as quick as possible to minimize oxidation of the thermoelectric surfaces. To accomplish this essential bond coating the gun is held very close to the work piece, approximately 4 inches. This distance is much less than what is typically used in the thermal spray industry for molybdenum. The molybdenum coating is built up to 0.006 inches "in approximately 0.0005" increments using typical molybdenum spray parameters for arc-wire guns. Using a Metco 5RG arc wire system with 14 gauge molybdenum, the atomizing air pressure is 80 psi +/- 5 psi, operating voltage is 32 VDC and the operating amperage is 175 amps +/- 10 amps. The wire clamps use pressure of 50 psi. The aluminum is intentionally deposited so it is not fully dense and strong. If the coating is too strong it will cause significant stresses to develop near the molybdenum - thermoelectric material interface that can cause cracks or failure in the thermoelectric materials. The aluminum is deposited with the gun approximately 17" from the work piece. This distance is much more that what is typically used in the thermal spray industry for aluminum. For a 14 gauge aluminum wire the atomizing air pressure is 50 psi +/- 5 psi, the operating voltage is 29 VDC and the operating current is 150 +/- 10 amps. The wire clamps use air pressure of 45 psi. In this manner the aluminum deposited is sufficiently conductive to act as a good electrical conductor. The above parameters were developed for the thermoelectric elements that are approximately .200" x .200" in cross section. As the cross-sectional dimensions are reduced it is possible to relax the spray parameters since the thermal stresses developed near the molybdenum-aluminum interface are less, and therefore less susceptible to cracking. Both coatings are applied using the system shown in FIGS. 19 A and B with the mandrel rotating at 55 rpm and the spray gun running back and forth at speeds of about 0.2 inch per second. After the surfaces are coated we remount the modules to expose the unsprayed surface and repeat the above described process.

### Reducing the Module Surfaces

The sprayed surfaces must be reduced down to expose the eggcrate walls. To do this we position a sprayed module in the mounting chuck of a surface finishing or lapping machine. Our preferred finishing methods utilize either precision sanding or double side lapping, or both. We reduce the surface of the module to the appropriate height as measured from eggcrate tab 62 shown in FIGS. 11 and 12. We then remove the module from the chuck, reverse the module and reduce the opposite face of the module until the module surface is the appropriate height from the egg crate tab.

### APPLYING INSULATING SEAL

At this point the module is complete but is susceptible to moisture accumulation in the spaces between the element and the egg crate wall. This moisture is a thermal short and can cause corrosion over time. The module can be sealed by bonding a thin layer of aluminum sheet to each face using a polyimide film made by DuPont. The film is known by the trade name Kapton and a suitable film type is 100KJ, When heated under pressure this film will bond to the surface to which it is in contact. By positioning a piece of this Kapton film between the surface of the module and a thin sheet of aluminum the aluminum is tightly bonded to the module but is not in electrical contact to the module since it is isolated by the Kapton film. The Kapton-aluminum seal is shown in FIG. 27 with the thickness of both layers being exaggerated. This constitutes the preferred embodiment but the aluminum sheet could be replaced with copper sheet or any other metal, ceramic, glass or plastic sheet. The self adhesive Kapton film could also be replaced with similar films or coatings that are used with or without adhesive. It is also possible to use an insulator film and a conductor film without having them bonded.

This process of sealing the faces of the modules has the additional advantages of greatly reinforcing the elements of the modules. It also makes the surface of the module electrically isolated from the electrical circuit of the module. This eliminates the need (and associated cost) for isolating the module electrically from the heat source or heat sink when installing the module in a thermoelectric generator or in a cooling system.

### INSPECTION

We heat the hot surface of the module to 250 C and cool the cold side of the module to 50 C. We then measure the open circuit voltage of the module. It should be about 3.2 volts with bismuth telluride elements. We then apply an electrical load to the module until the voltage drops to 1.6 volts and measure the current. We calculate the power produced by the module as P=I X V. We expect a power level of at least 13 watts for the bismuth telluride elements.

### Thermoelectric Generator Unit

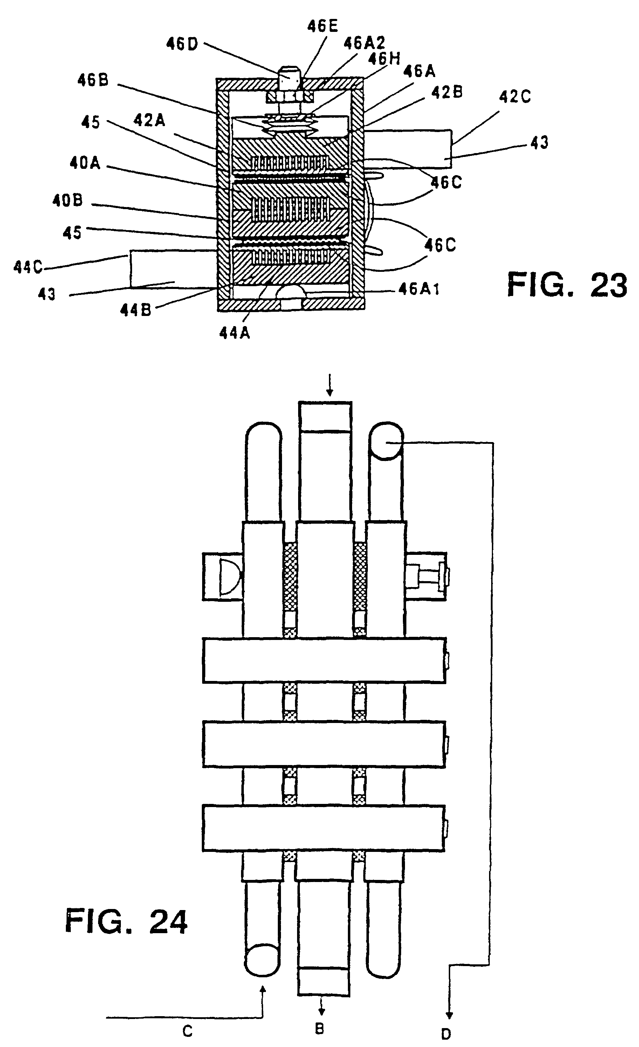

A schematic drawing of a thermoelectric generator 28 is shown in FIG. 24 and a detailed version of generator is shown in FIG. 23. The unit comprises of one hot side heat exchanger 40, a first cold side heat exchanger 42, connecting hose 43 and a second cold side heat exchanger 44, eight thermoelectric modules 45 electrically connected in series and four spring loaded compression elements 46. The hot glycol enters hot side heat exchanger 40 at A and exits at B as shown in FIG. 24. The cool glycol enters one of the cold side heat exchangers 42 at C, passes through it and connecting hose 43 (shown in FIG. 20) and then passes through the other cold side heat exchanger 44 and exits at D, as shown in FIG. 24.

### Heat Exchangers

The hot side heat exchanger 40 is in this embodiment a welded steel structure. The body of the heat exchanger is 14 1/2 inches long and 3 inches wide. it is basically constructed of two identical machined finned sections 40 A and 40 B. These two sections are welded together and nipples 40 C and 40 D are welded at opposite ends of the heat exchanger to form a finned passage for the hot glycol. Each of the cold side heat exchangers is also a welded steel structure. They each comprise a finned section 42 A and 44 A and a cover plate 42 B and 44 B which are welded together and to nipples 42 C and 44 C to form a finned passage for the cool glycol.

### Compression Elements

Compression elements 46 comprise a steel frame 46 A which is basically a four sided rectangular frame with outside dimensions of 5.64 inches high, 3 3/4 inches wide and 1 3/4 inches thick. The frame provides a rectangular space 3.12 inches wide and 5.02 inches high for the heat exchangers and the thermoelectric modules 45 to fit into. Each frame also comprises a thrust button 46 A 1 and a nut plate 46 A 2 containing a hexagonal nut matching space. Compression elements 46 each provide about 1000 pound compression on the heat exchangers and the thermoelectric modules. This is accomplished with a Bellville spring stack 46 B, each of which are centered over two thermoelectric modules 45 each of which in turn are sandwiched between two thin (0.01 inch thick) alumina (Al₂O₃) wafers 46 C as shown in FIG. 23. It should be noted that alumina wafers 46 C will not be required if thermoelectric modules 45 are already covered by insulating seals such as the Kapton-aluminum seal shown in FIG. 27. The load is provided by tightening adjustment screw 46 D through nut 46 E to compress spring stack 46 B. Torque produced by screw 46 D on nut 46 E is resisted by nut plate 46 A 2. Upward thrust produced by screw 46 D is absorbed on the top side by adjusting nut 46 E and then support frame 46 A to thrust button 46 A 1 located on the opposite side of compression element 46. Downward thrust from screw 46 D is absorbed on the bottom side by by load washer 46 H and the spring stack 46 B . Thus, the two thermoelectric modules 45 are held in tight compression between the heat exchangers by opposite forces of about 1000 pounds provided by thrust button 46 A 1 and spring stack 46 B.

### Well Head Dehydration Installation

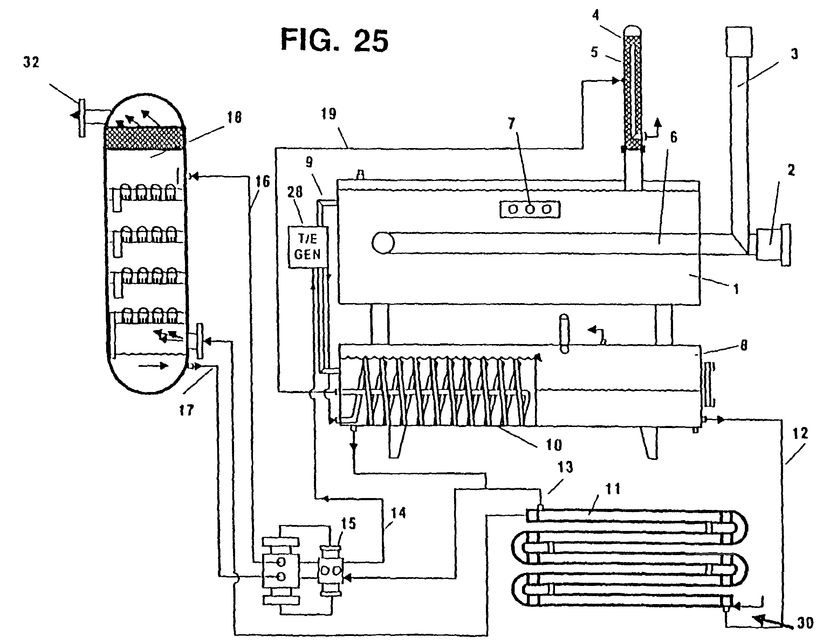

In one preferred embodiment of the present invention thermoelectric generating unit 28 is inserted as shown in FIG. 25 in a well head dehydration plant. This thermoelectric generator utilizes as its heat source the hot (375 degrees F) dry glycol exiting reboiler 1 through pipe 9 and utilizes as its cold sink the cool (60 degrees F) wet glycol entering preheat heat exchanger 8 through pipe 14.

### Performance of the Unit

The total output of the eight thermoelectric modules connected in series, with a hot side temperature of 375 degrees F and a cold side temperature of about 65 degrees F, will be in the range of about 62 watts at about 12 volts. Additional power and higher voltages can be obtained by adding additional thermoelectric generator units. As indicated only a very small percentage of available waste energy of the dehydration plant was utilized in the above described arrangement.

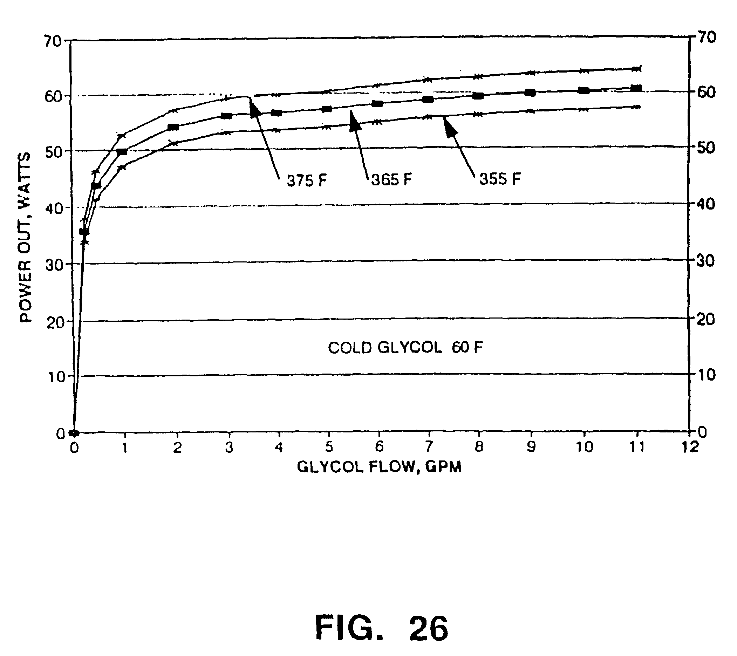

FIG. 26 shows curves of power output as a function of glycol flow rate for several hot glycol temperatures. For flow rates greater than 10 gpm, it is feasible to connect more than one unit in series to provide increased power. For flow rates above 30 gpm generators should preferably be connected in parallel. For flow rates outside these ranges a redesign of the unit may be preferably making it longer or wider.

Engineers installing the generator in the field may elect to incorporate bypass lines and valves to allow them to bypass the generator. This would allow the generator to be removed from service if not needed or for repair. A flow control valve could be provided if desired although in most cases it would not be needed. If the generator is to be used to provide cathodic protection, the generator would normally be connected to a constant current regulator which will automatically vary the system impedance to match system requirements. If the generator is to be used to provide power for lighting, instruments or communication, the generator would normally be connected to a constant voltage shunt regulator. A battery is not required to make the system operate. However, if the generator is to be used to provide power for a system, such as communication, where the short term peak power requirements is higher than the normal power output from the generator, then a battery and battery and a battery regulator would be included to carry the short term high peak loads. All of this extra equipment can be obtained "off the shelf".

The foregoing description of the present invention has been presented for the purpose of illustration and is not intended to limit the invention to the precise form disclosed. It is understood that many modifications and changes may be effected by those skilled in the art. For example, thermoelectric modules other than the one described could be utilized in which case details of the heat exchanger and compression elements would probably need to be modified appropriately. It is feasible to make modules with many more thermoelectric elements in which case a single thermoelectric module may be sufficient to provide the required voltage. Other well known methods of holding the thermoelectric elements in good thermal contact with the heat exchangers could be used. There maybe advantages of tapping into hot and cold glycol lines at locations other than those described. The heat exchangers were described as welded carbon steel units. These heat exchangers could be made with other well known techniques utilizing teachings of this specification. When sales are high enough to justify it, Applicants plan to manufacture the heat exchangers using aluminum castings. This should greatly reduce the cost.

As to the thermoelectric modules, many other materials besides Zenite can be used for injection molded eggcrates. These include Xydar( manufactured by Amaco which is substantially equivalent to Zenite),polyethylene, silicones, teflons, and many others. Zenite was primarily selected because of its superior properties (i.e., melting point, thermal stability, etc.) at higher temperatures. Also it should be possible to use a ceramic material in the form of a "slip". (This is the term used for describing a fine ceramic material suspended in a liquid.) After molding, the liquid is removed by drying and /or the mold (typically plaster of paris) absorbing the liquid. The components are then sintered to give them strength. Zenite, in fact, contains a fine glass powder filler to reduce material costs and control other material properties. This filler could be some other material such as carbon or come chopped fibers made from fiber glass, graphite fibers, etc. Other moldable materials which could be used are organic precursors that transform from the organic to the inorganic state when heated or inorganic materials themselves. Materials of this nature would be very desirable for higher temperature eggcrates that would be used with high temperature thermoelectric materials such as PbTe and SiGe which operate at temperatures greater than 350 °C which is typically an upper limit on most organic materials. These materials would allow the eggcrate to be loaded to higher values at temperatures where organic materials typically lose their strength. Phosphate and silicate pastes and cements might also be used for the eggcrate material for high temperature applications.

Other methods for fabricating the gapless eggcrate may be used instead of the described injection molding method. These methods include:

### Casting

Several methods of casting would be suitable for the fabrications of egg crates. Two part epoxies of resins could be poured into a mold similar to the mold described and cured to form the eggcrate. By using castings the elements could be included in the mold as inserts and cast in place. Other materials that could be cast are plastics, glass, ceramics and metal alloys.

### Slip Casting

Another method of casting materials is slip casting. This is a forming process in which a mold, usually made of plaster of paris, draws water out of the slip. This leaves a deposit behind that conforms to the die (which would replicate the eggcrate structure) walls. The deposit is then dried and fired into a rigid structured. The "slip" is made up of a fine powder of the component to be made and it is suspended in water. The powder can be an organic or inorganic material.

### Blow Molding

Plastic film is inserted within a mold and blown to conform to the shape of the mold with pressured air.

### Extrusion Techniques

When an eggcrate is sectioned in planes parallel to the hot and cold surfaces of the module, three different profiles are possible. These three profiles can be extruded. Near the hot side the profile of the section would define the positions of the hot side connectors. Near the center of the egg crate the profile would define the positions of the elements and near the cold side of the egg crate the profile will define the position of the cold side elements. Each of the profiles could be formed by extruding plastic, glass or ceramic (in the green or unfired state) through an extrusion die. The extrusions would then be sliced to the appropriate thickness and laminated together to form the completed gapless eggcrate. It is also possible that a single extrusion profile could be sliced into the appropriate thickness and then subsequently formed using various techniques into the desired shape on the ends (to create stops and to accommodated the electrodes). Ceramic extrusions would be fired after the forming operation.

### Vacuum Forming

Thin plastic sheets are formed over heated molds to take on the desired shape. The plastic is force over the mold with a vacuum or in some cases with pressurized air to provide a gapless eggcrate.

### Conventional Machining

The gapless eggcrate can be formed by machining the spaces for the elements in a block of plastic material. Even some machinable ceramic materials could be drilled, shaped milled etc. to form the desired eggcrate structure. Ultrasonic machining, laser machining and water jet machining techniques could also be used to form a gapless eggcrate from a block of plastic or ceramic material.

### Stamping

The gapless eggcrate can be formed by designing a tool that would punch the required size of square holes in sheet of material. The stops at the bottom of the holes could then be formed in a second operation that would transpose some of the material from to frame so it acted as a stop.

### Die Casting

The material to be formed (plastic, glass, ceramic slurry or metal) is poured into a mold cavity to form the desired shape of a gapless eggcrate.

### Powder Pressing

Metal, plastic, ceramic or glass powders are pressed into a die with sufficient force to take on the shape of the punch and die combination (the shape of the gapless eggcrate). The green part is then ejected and can subsequently be fired to increase strength.

### Forging

The material to be formed is repeatedly hammered between two halves of a mold until the desired shape of the mold (the gapless eggcrate) is imparted to the piece being formed.

Accordingly it is intended by the appended claims to cover all modifications and changes as fall within the true spirit and scope of the invention.

## Claims

1. A method of fabricating a thermoelectric module comprising the steps of: forming an insulating eggcrate from an electrically insulating material using a casting or molding process, said eggcrate defining a plurality of spaces for thermoelectric elements, each space having at least four insulating walls without gaps, fabricating a plurality of thermoelectric elements each element being shaped to fit into one of said plurality of spaces, inserting said plurality of thermoelectric elements into said plurality of spaces, providing electrical connections on one side of said eggcrate, defining a hot side, and providing electrical connections on the other side of said eggcrate, defining a cold side, so as to connect said plurality of thermoelectric elements in series and provide a thermoelectric module, **characterised in that** said fabricating step comprises the steps of fabricating a plurality of p-type thermoelectric elements, each element being shaped to fit into one of said plurality of spaces and fabricating a plurality of n-type thermoelectric elements each element being shaped to fit into one of said plurality of spaces, and **in that**, in said inserting step, said plurality of p-type thermoelectric elements and said plurality of n-type thermoelectric elements are inserted into a plurality of said thermoelectric spaces in a predetermined pattern, and further **characterised in that** said step of providing electrical connections on the hot side and the cold side is effected utilising a process of thermal spraying a metallized coating on said hot and cold sides.

2. A method according to Claim 1 wherein, after said thermal spraying of metallized coating on said hot and cold sides, the sprayed surfaces are ground down to expose the insulating eggcrate walls except where connections between the elements are desired.

3. A method according to Claim 1 or Claim 2 wherein each said space is bounded by four walls providing respective edge surfaces and wherein, in said grinding step, the edge surfaces of three of the four walls bounding each of said plurality of spaces are exposed.

4. A method according to any of Claims 1 to 3 further comprising the steps of covering both hot and cold surfaces with an electrically insulating film.

5. A method according to Claim 4 further comprising the step of covering said electrically insulating film with a metal layer.

6. A method according to Claim 5, wherein said electrically insulating film comprises adhesive film.

7. A method according to any of Claims 1 to 6, wherein said eggcrate is so molded as to provide two solid plastics sections in said eggcrate having a volume of 0.5 cubic centimeters of plastic for solid attachment of electrical leads.

8. A method according to any of Claims 1 to 7 wherein said casting or molding process is an injection molding process.

9. A method according to Claim 8 wherein said injection molding process comprises injecting an organic precursor into a mold and heating the precursor to transform it into an inorganic state.

## Patentansprüche

1. Verfahren zum Herstellen eines thermoelektrischen Moduls, wobei das Verfahren die folgenden Schritte umfaßt: Bilden eines isolierenden Eierrahmens aus einem elektrisch isolierenden Material mit Hilfe eines Gieß- oder eines Formverfahrens, wobei der Eierrahmen mehrere Räume für thermoelektrische Elemente definiert, die jeweils wenigstens vier isolierende Wände ohne Lücken aufweisen, Herstellen mehrerer thermoelektrischer Elemente, die jeweils geformt sind, um in einen der mehreren Räume zu passen, Einbringen der mehreren thermoelektrischen Elemente in die mehreren Räume, Ausbilden elektrischer Verbindungen auf einer Seite des Eierrahmens, Definieren einer Warmseite und Ausbilden elektrischer Verbindungen auf der anderen Seite des Eierrahmens, Definieren einer Kaltseite, so daß die mehreren thermoelektrischen Elemente in Reihe verbunden sind, und Bilden eines thermoelektrischen Moduls, **dadurch gekennzeichnet, daß** der Herstellungsschritt die Schritte zum Herstellen mehrerer thermoelektrischer Elemente vom p-Typ, die jeweils geformt sind, um in einen der mehreren Räume zu passen, und mehrerer thermoelektrischer Elemente vom n-Typ umfassen, die jeweils geformt sind, um in einen der mehreren Räume zu passen, daß bei dem Schritt zum Einbringen die mehreren thermoelektrischen Elemente vom p-Typ und die mehreren thermoelektrischen Elemente vom n-Typ in mehrere der thermoelektrischen Räume in einer vorbestimmten Anordnung eingebracht werden, und daß der Schritt zum Bilden der elektrischen Verbindungen auf der Warmseite und der Kaltseite bewirkt wird, indem ein Prozeß des thermischen Sprühens einer metallisierten Beschichtung auf die Warm- und die Kaltseite genutzt wird.

2. Verfahren nach Anspruch 1, **dadurch gekennzeichnet, daß** nach dem thermischen Sprühen der metallisierten Beschichtung auf die Warm- und die Kaltseite die gesprühten Oberflächen entfernt werden, um die isolierenden Eierrahmen freizulegen, außer wo Verbindungen zwischen den Elementen gewünscht sind.

3. Verfahren nach Anspruch 1 oder 2, **dadurch gekennzeichnet, daß** jeder Raum von vier Wänden begrenzt wird, welche jeweilige Randflächen bilden, und daß bei dem Schritt zum Schleifen die Randflächen von drei der vier Wände, die jeweils die mehreren Räume begrenzen, freigelegt werden.

4. Verfahren nach einem der Ansprüche 1 bis 3, **gekennzeichnet durch** Schritte zum Bedecken der Warm- und der Kaltfläche mit einem elektrisch isolierenden Film.

5. Verfahren nach Anspruch 4, **gekennzeichnet durch** einen Schritt zum Bedecken des elektrisch isolierenden Films mit einer Metallschicht.

6. Verfahren nach Anspruch 5, **dadurch gekennzeichnet, daß** der elektrisch isolierende Film einen Haftfilm aufweist.

7. Verfahren nach einem der Ansprüche 1 bis 6, **dadurch gekennzeichnet, daß** der Eierrahmen so geformt ist, daß zwei feste Plastikabschnitte in dem Eierrahmen ein Volumen von 0,5 Kubikzentimetern Plastik für ein festes Anbringen von elektrischen Anschlußdrähten aufweist.

8. Verfahren nach einem der Ansprüche 1 bis 7, **dadurch gekennzeichnet, daß** der Gieß- oder der Formprozeß ein Spritzgießprozeß ist.

9. Verfahren nach Anspruch 8, **dadurch gekennzeichnet, daß** der Spritzgießprozeß das Einspritzen eines organischen Zwischenstoffes in eine Form und das Erwärmen des Zwischenstoffes zum Umwandeln in einen inorganischen Zustand umfaßt.

## Revendications

1. Procédé pour fabriquer un module thermoélectrique comprenant les étapes consistant à: former un casier alvéolé isolant en un matériau électriquement isolant en utilisant le procédé de coulée ou de moulage, ledit casier alvéolé définissant une pluralité d'espaces pour les éléments thermoélectriques, chaque espace possédant au moins quatre parois isolantes sans interstices, fabriquer une pluralité d'éléments thermoélectriques dont chacun est conformé de manière à être inséré dans l'un de ladite pluralité d'espaces, insérer ladite pluralité d'éléments thermoélectriques dans ladite pluralité d'espaces et établir des connexions électriques d'un côté dudit casier alvéolé, définir un côté chaud et prévoir des connexions électriques sur l'autre côté dudit casier alvéolé, définir un côté froid, de manière à connecter ladite pluralité d'éléments thermoélectriques en série et produire un module thermoélectrique, **caractérisé en ce que** ladite étape de fabrication comprend les étapes consistant à fabriquer une pluralité d'éléments thermoélectriques de type p, chaque élément étant conformé de manière à être inséré dans l'un de ladite pluralité d'espaces, et fabriquer une pluralité d'éléments thermoélectriques de type n, chaque élément étant conformé de manière à être inséré dans l'un de ladite pluralité d'espaces, lorsque, lors de ladite étape d'insertion, ladite pluralité d'éléments thermoélectriques de type p et ladite pluralité d'éléments thermoélectriques de type n sont insérés dans une pluralité desdits espaces thermoélectriques dans un réseau prédéterminé, et **caractérisé en outre en ce que** ladite étape consistant à prévoir des connexions électriques sur le côté chaud et sur le côté froid est exécutée en utilisant un procédé de pulvérisation thermique d'un revêtement métallique sur lesdits côtés chaud et froid.

2. Procédé selon la revendication 1, selon lequel, après ledit dépôt par pulvérisation thermique du revêtement métallisé sur lesdits côtés chaud et froid, entre les surfaces pourvues du dépôt de pulvérisation pour exposer les parois du casier alvéolé isolant hormis à l'endroit où des connexions entre les éléments sont désirés.

3. Procédé selon la revendication 1 ou la revendication 2, selon lequel chacun desdits espaces est délimité par quatre parois formant des surfaces de bord respectives, et selon lequel, lors de ladite étape de creusement, on expose les surfaces de bord de trois des quatre parois délimitant chacun de ladite pluralité d'espaces.

4. Procédé selon l'une quelconque des revendications 1 à 3, comprenant en outre les étapes consistant à recouvrir les surfaces chaude et froide avec un film électriquement isolant.

5. Procédé selon la revendication 4, comprenant en outre l'étape consistant à recouvrir ledit film électriquement isolant avec une couche métallique.

6. Procédé selon la revendication 5, selon lequel ledit film électriquement isolant comprend un film adhésif.

7. Procédé selon l'une quelconque des revendications 1 à 6, selon lequel ledit casier alvéolé est moulé de manière à former deux sections en matière plastique solide dans ledit casier alvéolé, possédant un volume de 0,5 centimètres cube de matière plastique pour une fixation solide de fils électriques.

8. Procédé selon l'une quelconque des revendications 1 à 7, selon lequel ledit processus de coulée ou de moulage est un processus de moulage par injection.

9. Procédé selon la revendication 8, selon lequel ledit procédé de moulage par injection comprend l'injection d'un précurseur organique dans un moule et le chauffage du précurseur pour sa transformation l'amenant dans un état minéral.
